# EUROPEAN PATENT APPLICATION

(11) **EP 2 352 182 A1**
(43) Date of publication of application: **03.08.2011**
(21) Application number: 09821994.2
(22) Date of filing: 19.10.2009
(51) Int. Cl.: H01L 33/32, H01L 21/205, H01S 5/343

(54) **METHOD FOR MANUFACTURING NITRIDE SEMICONDUCTOR LIGHT EMITTING ELEMENT AND METHOD FOR MANUFACTURING EPITAXIAL WAFER**

(30) Priority: 20.10.2008 JP 2008270065; 29.09.2009 JP 2009225355
(71) Applicant: Sumitomo Electric Industries, Ltd., Chuo-ku Osaka-shi Osaka 541-0041 (JP)
(72) Inventor: SUMITOMO Takamichi, Itami-shi Hyogo 664-0016 (JP); AKITA Katsushi, Itami-shi Hyogo 664-0016 (JP); KYONO Takashi, Itami-shi Hyogo 664-0016 (JP); YOSHIZUMI Yusuke, Itami-shi Hyogo 664-0016 (JP)
(74) Representative: Grünecker, Kinkeldey, Stockmair & Schwanhäusser Anwaltssozietät
(86) International application number: PCT/JP2009/067988
(87) International publication number: WO 2010/047297

(57) **Abstract**

Provided is a method of fabricating a nitride semiconductor light emitting device, and this method can reduce degradation of a well layer during formation of a p-type gallium nitride based semiconductor region and a barrier layer. After growth of a gallium nitride based semiconductor region 13, a barrier layer 2 1 a is grown on a substrate 11. The barrier layer 21a is formed at a growth temperature TB during a period from a time t1 to t2. The growth temperature TB (= T2) is in the range of not less than 760 Celsius degrees and not more than 800 Celsius degrees. At the time t2, the growth of the barrier layer 21a is completed. After the growth of the barrier layer 21a, a well layer 23a is grown on the substrate 11 without interruption of growth. The well layer 23a is formed at a growth temperature TW (= T2) during a period from the time t2 to t3. The growth temperature TW is the same as the growth temperature TB and can be in the range of not less than 760 Celsius degrees and not more than 800 Celsius degrees. An indium composition of the well layer 23a is not less than 0.15. Next, the growth of the well layer and barrier layer is repeatedly carried out without interruption of growth.

## Description

### Technical Field

The present invention relates to a method for fabricating a nitride semiconductor light emitting device and a method for fabricating an epitaxial wafer.

### Background Art

Patent Literature 1 discloses a method for fabricating a semiconductor element. In this method, a number of semiconductor layers are grown in order by crystal growth of III nitride compound semiconductors to form an active layer. This active layer has the semiconductor layers that contain indium (In). After formation of the active layer, at least one p-type semiconductor layer is grown thereon. The crystal growth temperature of the p-type semiconductor layer is not less than 820 Celsius degrees and not more than 910 Celsius degrees. A carrier gas used for carrying a raw material gas for the p-type semiconductor layer is rare gas (He, Ne, Ar, Kr, Xe, Rn) or nitrogen gas (N₂).

Patent Literature 2 discloses a method of fabricating a nitride semiconductor light emitting device. In this method, after forming an active layer thereof, a p-type Al_{z}Ga_{1-z}N film is grown on the active layer at a film formation temperature in the range of not less than 800 Celsius degrees and not more than 950 Celsius degrees.

Patent Literature 3 discloses a method of fabricating a light emitting device. After growing a well layer thereof, a part of a barrier layer is grown with increase in temperature and then the rest of the barrier layer is grown at a larger growth rate at a constant temperature. After the growth, the temperature is decreased to grow a well layer. This allows the formation of an MQW structure with excellent crystallinity and with high luminous efficiency.

### Citation List

### Patent Literature

Patent Literature 1: Japanese Patent Application Laid-open No. 2004-363401
Patent Literature 2: Japanese Patent Application Laid-open No. 2007-201099
Patent Literature 3: Japanese Patent Application Laid-open No. 2002-43618

### Summary of Invention

### Technical Problem

In Patent Literature 2, after formation of the active layer, the p-type AlGaN layer is grown at the growth temperature of 800 Celsius degrees to 950 Celsius degrees. In the methods of Patent Literatures 1 and 3, the growth temperature of the barrier layer is higher than that of the well layer. In Patent Literature 1, the growth temperature of the well layers is 730 Celsius degrees, and the growth temperature of the barrier layers is 885 Celsius degrees. After formation of the active layer, the p-type semiconductor layer is grown at the growth temperature of not less than 820 Celsius degrees and not more than 910 Celsius degrees. Excellent crystallinity of the active layer is maintained by employing the low growth temperature of the p-type semiconductor. In Patent Literature 3, after growth of the well layer, a part of the barrier layer is grown with increase in temperature, and the rest of the barrier layer is grown at the temperature after completion of the temperature increase. This suppresses deterioration of the well layer and improves the crystal quality of the barrier layer.

The growth temperature that the well layer of InGaN can be grown is made lower with increase in indium composition of the InGaN. Accordingly, a large temperature difference is made between the growth temperature of the barrier layer and the growth temperature optimum for the well layer of a certain large indium composition.

When the growth temperature of the well layer is different from the growth temperature of the barrier layer, the substrate temperature has to be increased to the growth temperature of the barrier layer after having grown the well layer. During a period of this temperature change, the well layer is exposed to the temperature higher than the growth temperature of the well layer. Hence, the crystal quality of the well layer is degraded by the temperature change to the growth temperature of the barrier layer, and the degree of the degradation depends upon the indium composition of the well layer. In the method of depositing a part of the barrier layer with change in temperature after growth of the well layer, it still remains that the well layer is also exposed to high temperature caused by the temperature change. Because of the change of temperature, strain due to stress between the barrier layer and the well layer is exerted on the well layer. According to Inventors' knowledge, growth of InGaN on a so-called semipolar plane is different from growth of InGaN on a c-plane.

It is an object of the present invention to provide a method of fabricating a nitride semiconductor light emitting device, and the method can reduce degradation of a well layer during formation of a p-type gallium nitride based semiconductor region and a barrier layer, and it is another object of the present invention to provide a method of fabricating an epitaxial wafer for the nitride semiconductor light emitting device.

### Solution to Problem

One aspect of the present invention is a method for fabricating a nitride semiconductor light emitting device. This method comprises the steps of: (a) growing a barrier layer for an active layer on a primary surface of a semiconductor region of a gallium nitride based semiconductor; (b) growing a well layer for the active layer on the barrier layer; and (c) growing a p-type gallium nitride based semiconductor region on the active layer. The primary surface of the semiconductor region is inclined with respect to a c-plane of the gallium nitride based semiconductor to have semipolar nature; the well layer comprises InGaN; an indium composition of the well layer is not less than 0.15; the barrier layer comprises a gallium nitride based semiconductor different from that of the well layer; a growth temperature of the well layer is the same as a growth temperature of the barrier layer; the p-type gallium nitride based semiconductor region includes one or more p-type gallium nitride based semiconductor layers, and a growth temperature of each of the p-type gallium nitride based semiconductor based layers is larger than the growth temperature of the well layer and the growth temperature of the barrier layer.

Another aspect of the present invention is a method for fabricating an epitaxial wafer for a nitride semiconductor light emitting device. This method comprises the steps of: (a) growing a barrier layer for an active layer on a primary surface of a semiconductor region, the semiconductor region comprising a gallium nitride based semiconductor; (b) growing a well layer for the active layer on the barrier layer; and (c) growing a p-type gallium nitride based semiconductor layer on the active layer. The primary surface of the semiconductor region is inclined with respect to a c-plane of the gallium nitride based semiconductor to have semipolar nature; the barrier layer comprises a gallium nitride based semiconductor different from that of the well layer; the well layer comprises InGaN; an indium composition of the well layer is not less than 0.15; a growth temperature of the well layer is the same as a growth temperature of the barrier layer; the p-type gallium nitride based semiconductor region includes one or more p-type gallium nitride based semiconductor layers, and a growth temperature of each of the p-type gallium nitride based semiconductor layers is larger than a growth temperature of the well layer and a growth temperature of the barrier layer.

In the above method, since the growth temperature of the well layer is the same as the growth temperature of the barrier layer, degradation of crystal quality of the well layer is suppressed during growth of the barrier layer. Although the growth temperature of each of the p-type gallium nitride based semiconductor layers is larger than the growth temperature of the well layer and the growth temperature of the barrier layer, the degradation of crystal quality of the well layer is suppressed during growth of the p-type gallium nitride based semiconductor layers because the growth temperature of the well layer is the same as the growth temperature of the barrier layer.

In the method according to the present invention, the growth temperature of the well layer and the growth temperature of the barrier layer can be not less than 760 Celsius degrees and not more than 800 Celsius degrees. In this method, since both of the growth temperatures of the well layer and the barrier layer are the same temperature in the range of not less than 760 Celsius degrees and not more than 800 Celsius degrees, the crystal qualities of the well layer and the barrier layer both are made excellent.

In the method according to the present invention, the growth temperature of the p-type gallium nitride based semiconductor region can be more than 950 Celsius degrees and not more than 1000 Celsius degrees. In this method, since the growth temperature of the p-type gallium nitride based semiconductor region is in the foregoing temperature range, the crystal quality and electrical characteristics of the p-type gallium nitride based semiconductor region both are made excellent, whereas the crystal quality of the active is hardely deteriorated during the growth of the p-type gallium nitride based semiconductor region.

The method according to the present invention can be configured as follows: the indium composition of the well layer is not less than 0.20 and not more than 0.25; a peak wavelength of light emitted from the active layer is not less than 500 nm; and an emission intensity of the light from the active layer shows a maximum at the peak wavelength. In this method, when the indium composition of the well layer is in the foregoing range, the degradation of crystal quality of the well layer is suppressed during the growth of the p-type gallium nitride based semiconductor layers and the barrier layer if the growth temperature of the well layer is the same as the growth temperature of the barrier layer.

In the method according to the present invention, the p-type gallium nitride based semiconductor region can include an AlGaN layer. In this method, the crystal quality and electrical characteristics of the AlGaN layer of the p-type gallium nitride based semiconductor region both are made excellent.

In the method according to the present invention, a thickness of the p-type gallium nitride based semiconductor region can be not less than 40 nm and not more than 200 nm. In this method, since the p-type gallium nitride based semiconductor region is grown at the high temperature as described above, the creation of pits is suppressed in the p-type gallium nitride based semiconductor region. Furthermore, since the surface of the p-type gallium nitride based semiconductor region in the growth can be kept flat, it becomes feasible to deposit the p-type semiconductor region thick in order to decrease the resistance of the p-type gallium nitride based semiconductor region.

The method according to the present invention can further comprise the step of preparing a substrate which comprises a gallium nitride based semiconductor. A primary surface of the substrate is inclined with respect to a c-plane of the gallium nitride based semiconductor.

According to this method, the substrate has the primary surface comprising the gallium nitride based semiconductor. With use of this substrate, it is feasible to obtain a semiconductor region on a semipolar plane inclined with respect to the c-plane.

The method according to the present invention can further comprise the step of preparing a substrate which comprises a gallium nitride based semiconductor. The primary surface of the substrate is inclined with respect to the (000-1) plane that is the reverse of a c-plane ((0001) plane).
According to this method, the substrate has the primary surface that comprises the gallium nitride based semiconductor. With use of this substrate, it is feasible to obtain a semiconductor region on a semipolar plane inclined with respect to the (000-1) plane.

In the method according to the present invention, an inclination angle of the primary surface of the substrate can be not less than 60 degrees and not more than 90 degrees. In the method according to the present invention, an inclination angle of the primary surface of the semiconductor region can be not less than 60 degrees and not more than 90 degrees. The both inclination angles can be defined on the basis of the (0001) plane or the (000-1) plane.

The method according to the present invention can further comprise the step of carrying out a thermal treatment of the substrate, prior to growth of the gallium nitride based semiconductor. An atmosphere of the thermal treatment contains at least ammonia and hydrogen. This method involves the thermal treatment in the atmosphere containing ammonia and hydrogen, thereby providing cleaning of the surface of the substrate and modification of the surface of the substrate.

In the method according to the present invention, a temperature difference between a maximum of the growth temperature of the p-type gallium nitride based semiconductor region and the growth temperature of the well layer can be not more than 250 Celsius degrees.

In the method according to the present invention, a normal vector normal to the primary surface of the semiconductor region can be inclined at the angle in the range of not less than 60 degrees and not more than 90 degrees with respect to a normal vector normal to either a c-plane ((0001) plane) or a (000-1) plane which is a back surface of the c-plane. In this method, the active layer is grown on the primary surface of the semiconductor region which has either of semipolar nature and nonpolar nature with inclination at the angle in the range of not less than 60 degrees and not more than 90 degrees. Since in this angle range an amount of the indium incorporation in growth of InGaN is excellent, the InGaN is formed with an excellent crystal quality.

In the method according to the present invention, the indium composition of the well layer can be not less than 0.20, and the active layer can be provided so as to generate light with a peak wavelength in the wavelength region of not less than 500 nm. This method is applicable to generation of light at a long wavelength.

In the method according to the present invention, the growth temperature of the well layer and the growth temperature of the barrier layer can be not more than 800 Celsius degrees and the growth temperature of the p-type gallium nitride based semiconductor region can be not more than 1000 Celsius degrees. In this method, since the growth temperature of the well layer is not more than 800 Celsius degrees, it is feasible to widen a range of change in the In composition of the InGaN layer. Since the growth temperature of the p-type gallium nitride based semiconductor region is not more than 1000 Celsius degrees, it is feasible to reduce thermal degradation of the InGaN layer.

In the method according to the present invention, the growth temperature of the well layer and the growth temperature of the barrier layer can be not less than 700 Celsius degrees and can be not more than 760 Celsius degrees. This method is applicable to formation of the active layer that can generate light with a peak wavelength among emission wavelengths of not less than 400 nm and not more than 540 nm. It is feasible to prevent the emission property from degrading due to the crystal quality of the InGaN layer.

In the method according to the present invention, the growth temperature of the p-type gallium nitride based semiconductor region can be more than 850 Celsius degrees. This method can suppress degradation of device characteristics due to increase in resistance of the p-type gallium nitride based semiconductor region. The growth temperature of the p-type gallium nitride based semiconductor region can be not more than 950 Celsius degrees. This method can reduce thermal degradation of the InGaN layer during the growth of the p-type gallium nitride based semiconductor region.

In the method according to the present invention, a temperature difference between a maximum of the growth temperature of the p-type gallium nitride based semiconductor region and the growth temperature of the well layer can be not more than 200 degrees. In the fabrication of the light emitting device, when the growth temperature of the InGaN well layer is relatively low or when the In composition of the InGaN well layer is relatively high, the quality of the InGaN layer is sensitive to thermal stress after film formation thereof. In order to avoid the thermal degradation of the InGaN layer, there is an upper limit to the growth temperature of the p-type gallium nitride based semiconductor region.

In the method according to the present invention, the indium composition of the well layer can be not less than 0.25 and not more than 0.35 and an lasing wavelength of light emitted from the active layer can be not less than 500 nm. By use of this method the active layer can be formed so as to generate light at a wavelength longer than green emission.

In the method according to the present invention, a thickness of the p-type gallium nitride based semiconductor region can be not less than 50 nm and not more than 700 nm. This method can provide excellent optical confinement from the whole p-type gallium nitride based semiconductor region. For example, a cladding layer can be not less than 50 nm and not more than 700 nm.

The method according to the present invention can further comprise an end face for an optical cavity of the nitride semiconductor light emitting device. An inclination angle of the primary surface of the substrate is preferably not less than 63 degrees and not more than 83 degrees. In this angle range, an excellent In incorporation performance is achieved in the growth of InGaN. Hence, the well layer is provided with a large variety of In composition, which is suitable for production of the active layer to generate light at the wavelength of not less than 500 nm.

The above objects and other objects, features, and advantages of the present invention will more readily become clear from the following detailed description of preferred embodiments of the present invention proceeding with reference to the accompanying drawings.

### Advantageous Effects of Invention

As described above, the present invention provides the method for fabricating the nitride semiconductor light emitting device, which can reduce the degradation of the well layer during the formation of the p-type gallium nitride based semiconductor region and the barrier layer. Furthermore, the present invention provides the method for fabricating the epitaxial wafer for the nitride semiconductor light emitting device, which can reduce the degradation of the well layer during formation of the p-type gallium nitride based semiconductor region and the barrier layer.

### Brief Description of Drawings

Fig. 1 is a drawing showing a flow of major steps in a method for fabricating a nitride semiconductor light emitting device and a method for fabricating an epitaxial wafer according to an embodiment of the present invention.
Fig. 2 is a drawing showing major steps in the method for fabricating the nitride semiconductor light emitting device and the method for fabricating the epitaxial wafer according to the embodiment of the present invention.
Fig. 3 is a drawing showing major steps in the method for fabricating the nitride semiconductor light emitting device and the method for fabricating the epitaxial wafer according to the embodiment of the present invention.
Fig. 4 is a drawing showing major steps in the method for fabricating the nitride semiconductor light emitting device and the method for fabricating the epitaxial wafer according to the embodiment of the present invention.
Fig. 5 is a drawing showing a timing chart showing change in substrate temperature and change in raw-material gas flow in steps of formation of an active layer and steps subsequent thereto.
Fig. 6 is a drawing showing a light emitting diode structure fabricated in Example 1.
Fig. 7 is a drawing showing full widths at half maximum of PL intensity in LED structures fabricated under various growth conditions.
Fig. 8 is a drawing showing a cathodoluminescence image in an LED structure obtained by growing well layers and barrier layers at the same temperature and a cathodoluminescence image in an LED structure obtained by growing well layers and barrier layers at different temperatures.
Fig. 9 is a drawing showing a flow of major steps in a method for fabricating a nitride semiconductor light emitting device and a method for fabricating an epitaxial wafer according to an embodiment of the present invention.
Fig. 10 is a drawing showing a flow of major steps in the method for fabricating the nitride semiconductor light emitting device and the method for fabricating the epitaxial wafer according to the embodiment of the present invention.
Fig. 11 is a drawing showing a timing chart showing change in substrate temperature and change in raw-material gas flow in steps of formation of a light emitting layer and steps subsequent thereto.
Fig. 12 is a drawing showing an epitaxial substrate for a laser diode structure fabricated in Example 2.
Fig. 13 is a drawing showing a laser diode structure fabricated in Example 2.

### Description of Embodiments

The expertise of the present invention can be readily understood in view of the following detailed description with reference to the accompanying drawings presented by way of illustration. Embodiments of the method for fabricating the nitride semiconductor light emitting device and the method for fabricating the epitaxial wafer according to the present invention, will be described below with reference to the accompanying drawings. The same portions will be denoted by the same reference signs as much as possible.

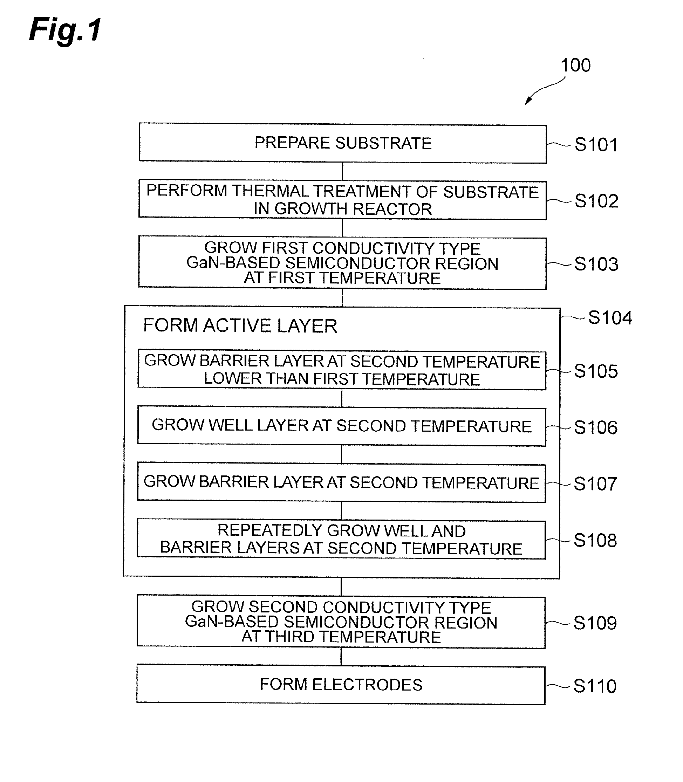

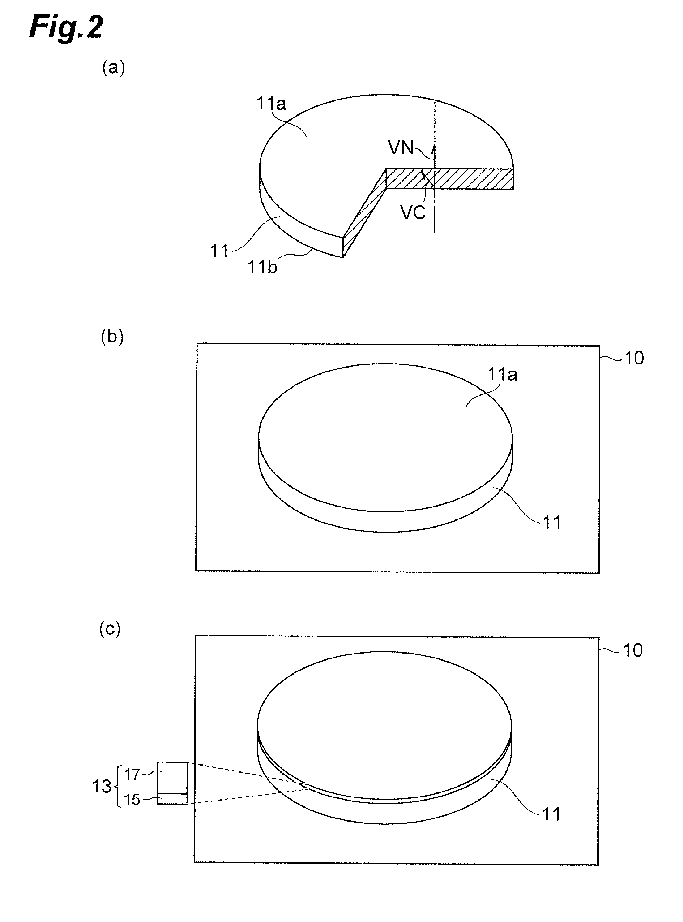

Fig. 1 is a drawing showing a flow of major steps in a method for fabricating a nitride semiconductor light emitting device and a method for fabricating an epitaxial wafer according to an embodiment of the present invention. Figs. 2 to 4 are drawings showing major steps in the method for fabricating the nitride semiconductor light emitting device and the method for fabricating the epitaxial wafer according to the present embodiment. The nitride semiconductor light emitting device encompasses, for example, a light emitting diode or a laser diode or the like.

In step S101 in the step flow 100, as shown in Fig. 2 (a), a substrate 11 comprising a gallium nitride based semiconductor is prepared and. The substrate 11 can comprises, for example, GaN, InGaN, AlGaN, or the like. In the substrate 11 a primary surface 11a and a back surface 11b are substantially parallel to each other. The primary surface 11a of this substrate 11 is inclined from a c-plane of the gallium nitride based semiconductor. A normal to the primary surface 11 a intersects with the c-axis of the gallium nitride based semiconductor at an inclination angle of not less than 60 degrees and not more than 90 degrees. Alternatively, the primary surface 11a of the substrate 11 can be inclined with respect to a (000-1) plane, which is opposite to a c-plane (or (0001) plane). When the primary surface is inclined in the foregoing angle range from the (000-1) plane, an amount of indium incorporation in growth of InGaN for a well layer is increased, as compared with InGaN grown on a (0001) plane and on a plane with inclination of not less than 60 degrees and not more than 90 degrees from the (0001) plane, and thus InGaN of a high In composition can be grown at a higher temperature than that on these planes. This allows the formation of the well layer having with excellent crystallinity. The primary surface 11a at the foregoing angle exhibits semipolar nature or nonpolar nature.

The substrate 11 is placed in a growth reactor 10. In step S102, as shown in Fig. 2 (b), the substrate 11 is subjected to a thermal treatment in the growth reactor 10. An atmosphere of the thermal treatment includes, for example, at least ammonia and hydrogen. This thermal treatment in the atmosphere containing ammonia and hydrogen allows cleaning of the substrate surface 11a and modification of the substrate surface 11a. As the substrate 11 is subjected to the thermal treatment in the growth reactor 10, the substrate 11 is provided with a modified primary surface 11c. This modification forms microsteps in the substrate surface 11c and the microsteps includes plural terraces.

Subsequently, a gallium nitride based semiconductor is grown on the substrate 11 by a metal-organic vapor phase epitaxial method using the growth reactor 10. In step S103, as shown in Fig. 2 (c), a first conductivity type gallium nitride based semiconductor region 13 is grown on the primary surface 11c of the substrate 11 in the growth reactor 10. The gallium nitride based semiconductor region 13 can include, for example, an n-type AlGaN buffer layer 15 and an n-type GaN layer 17. An aluminum composition of AlGaN is, for example, 0.12. An aluminum source, a gallium source, a nitrogen source, and silane are supplied to the growth reactor 10 to grow the n-type AlGaN buffer layer 15 at 1100 Celsius degrees on the primary surface 11c of the substrate 11. A gallium source, a nitrogen source, and silane are supplied to the growth reactor 10 to grow the n-type GaN layer 17 is grown at 1000 Celsius degrees on the n-type GaN buffer layer 15.

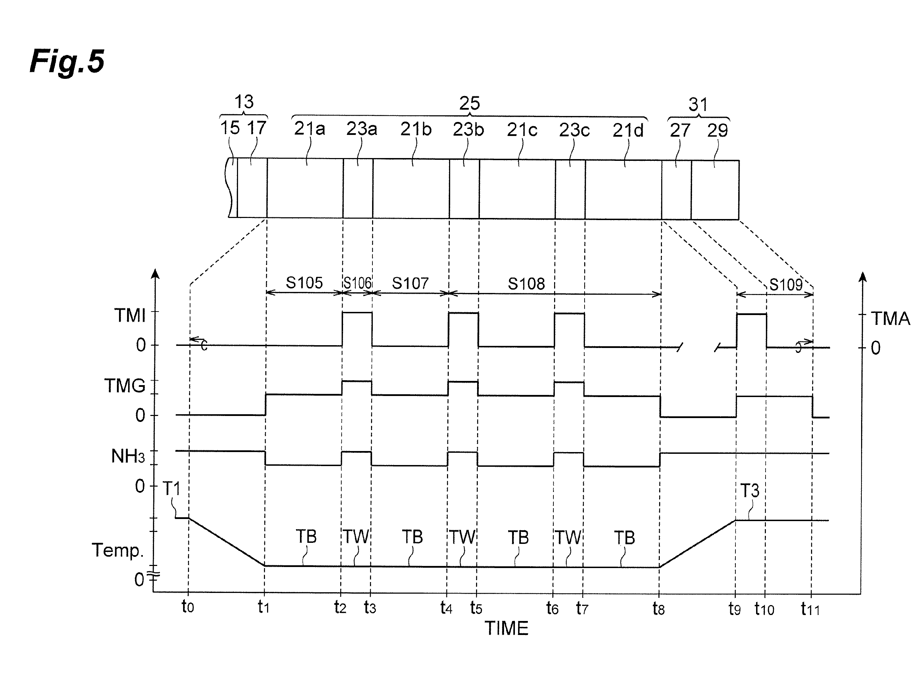

In step S104, an active layer is grown on the gallium nitride based semiconductor region 13 in the growth reactor 10. A primary surface of the semiconductor region on which the active layer is to be grown is inclined with respect to a c-plane of the gallium nitride based semiconductor to have semipolar nature. The formation of the active layer 25 will be described with reference to Fig. 5. First, the growth of the underlying semiconductor region on which the active layer 25 is to be grown is completed at a time t0. The growth reactor 10 is set at a first growth temperature T1 at the time t0. The temperature of the growth reactor 10 is changed from the growth temperature T1 to a second growth temperature T2 for barrier layer 21 (temperature TB in the present example) during a period from the time t0 to t1. During this change period, a nitrogen source such as ammonia is supplied into the growth reactor 10.

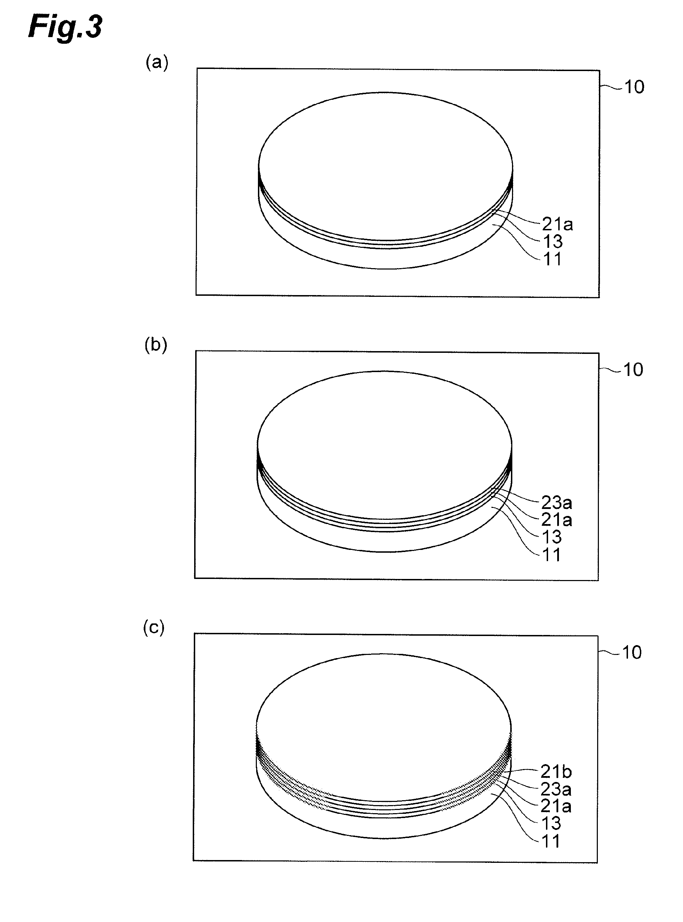

After the growth of the gallium nitride based semiconductor region 13, in step S105, as shown in Fig. 3 (a), a barrier layer 21a is grown on the substrate 11. The barrier layer 21a is formed at the growth temperature TB during a period from the time t1 to t2. The growth temperature TB (= T2) can be in the range of not less than 760 Celsius degrees and not more than 800 Celsius degrees. The barrier layer 21 a comprises a gallium nitride based semiconductor. This gallium nitride based semiconductor can comprise, for example, undoped GaN, undoped InGaN, undoped AlGaN, or the like. When the barrier layer 2 1 a is made of GaN, a gallium source and a nitrogen source are supplied to the growth reactor 10 to grow the barrier layer 2 1 a, for example, at 760 Celsius degrees. The thickness of the barrier layer 2 1 a can be, for example, not less than 10 nm and not more than 20 nm.

The growth of the barrier layer 21a is completed at the time t2. After the growth of the barrier layer 2 1 a, in step S106, as shown in Fig. 3 (b), a well layer 23a is grown on the substrate 11 without interruption of growth. The well layer 23a is formed at a growth temperature TW (= T2) during a period from the time t2 to t3. The growth temperature TW is the same as the growth temperature TB and can be in the range of not less than 760 Celsius degrees and not more than 800 Celsius degrees. The well layer 23a comprises an undoped InGaN semiconductor. An indium composition of the well layer 23a is not less than 0.15. When the well layer 23a is made of InGaN, an indium source, a gallium source, and a nitrogen source are supplied into the growth reactor 10 to grow the well layer 23a, for example, at 760 Celsius degrees. The thickness of the well layer 23a can be, for example, not less than 2 nm and not more than 5 nm.

The growth of the well layer 23a is completed at the time t3. After the growth of the well layer 23a, in step S107, as shown in Fig. 3 (c), a barrier layer 21 b is grown on the substrate 11 without interruption of growth. The barrier layer 21b is formed at the growth temperature TB during a period from the time t3 to t4. The growth temperature TB at this time is also the same as the growth temperature TW, and is in the range of not less than 760 Celsius degrees and not more than 800 Celsius degrees. The barrier layer 21b comprises an undoped GaN semiconductor. When the barrier layer 21b is made of GaN, a gallium source and a nitrogen source are supplied into the growth reactor 10 to grow the barrier layer 21b, for example, at 760 Celsius degrees, as described previously. The thickness of the barrier layer 21b can be, for example, not less than 10 nm and not more than 20 nm.

In step S108, the growth of the well layer and barrier layer is repeatedly carried out without interruption of growth. In the present example, well layers 23b and 23c are grown during a period from the time t4 to t5 and during a period from time t6 to t7, respectively, in the same manner as the well layer 23a. Barrier layers 21c and 21d are grown in the same manner as the barrier layer 21 b, during a period from the time t5 to the time t6 and during a period from the time t7 to a time t8, respectively.

In the growth of the active layer 25, the alternate growth of the barrier layers 21a-21d and the well layers 23a-23c are carried out continuously. The growth temperature TW (= T2) of the well layers 23a-23c and the growth temperature TB (= T2) of the barrier layers 2 1 a-2 1 d are equal to each other, and the temperature T2 is in the range of not less than 760 Celsius degrees and not more than 800 Celsius degrees. Accordingly, the crystal qualities of the well layers 23a-23c and the barrier layers 21a-21d both are made excellent.

In this method of fabricating the active layer 25, the barrier layers 21a-21d comprise the gallium nitride based semiconductor different from the well layers 23a-23c, but the growth temperature TW of the well layers 23a-23c is equal to the growth temperature TB of the barrier layers 21a-21d. Accordingly, degradation of crystal quality in the well layers 23a-23c is suppressed during the growth of the barrier layers 21a-21d.

In the growth of the active layer 25, the primary surface of the semiconductor region on which the barrier layer is grown is inclined with respect to a c-plane of the gallium nitride based semiconductor to exhibit semipolar nature. The primary surface of the semiconductor region on which the well layer is grown is inclined with respect to a c-plane of the gallium nitride based semiconductor, thereby having semipolar nature.

The growth of the active layer 25 is completed at the time t8. The growth reactor 10 is set at the temperature T2 at time t8. The temperature of the growth reactor 10 is changed during a period from time t8 to t9 from the temperature T2 to a growth temperature T3 for a p-type conductivity gallium nitride based semiconductor region.

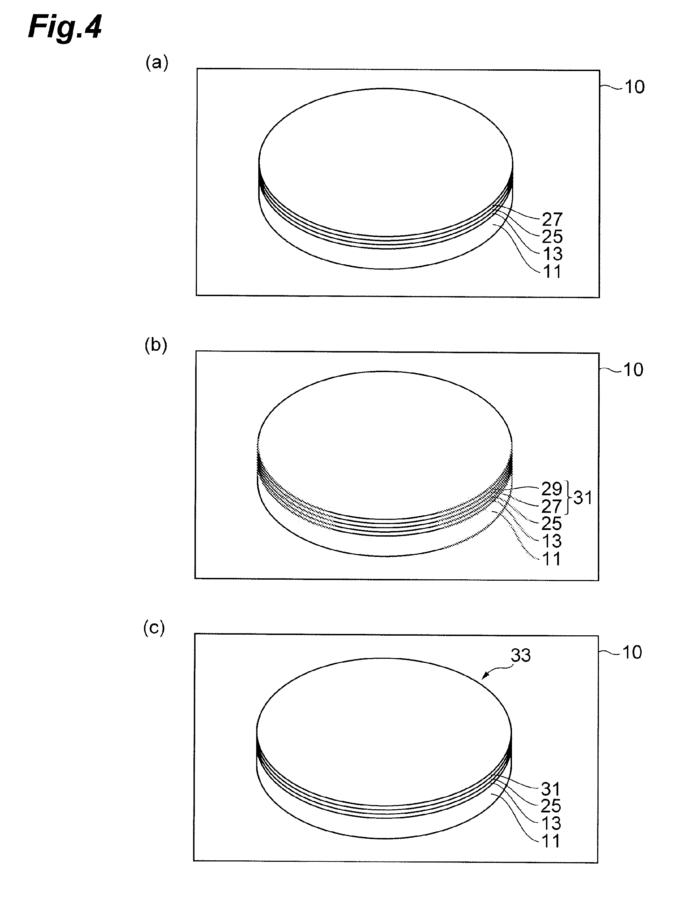

The change of temperature is completed at time t9, and the growth reactor 10 is set at the temperature T3. Subsequently, in step S109, the p-type conductivity gallium nitride based semiconductor region 31 is grown on the active layer 25 in the growth reactor 10. First, as shown in Fig. 4 (a), an electron block layer 27 is grown on the active layer 25. The electron block layer 27 comprises, for example, AlGaN and the growth of the p-type AlGaN layer is carried out during a period from time t9 to t10. An aluminum source, a gallium source, a nitrogen source and bis(cyclopentadienyl)magnesium (Cp₂Mg) are supplied into the growth reactor 10 to grow the AlGaN layer is grown at 1000 Celsius degrees on the substrate 11. An aluminum composition of AlGaN is, for example, 0.18.

Next, as shown in Fig. 4 (b), a contact layer 29 is grown on the active layer 25. The growth of the contact layer 29 is carried out during a period from time t10 to t11. The contact layer 29 is made of, for example, a p-type GaN layer, and the p-type GaN layer is grown at 1000 Celsius degrees on the electron block layer by supplying a gallium source, a nitrogen source, and Cp₂Mg into the growth reactor 10. After the growth of the AlGaN layer for the electron block layer 27, growth of the p-type GaN layer for the contact layer 29 is carried out without temperature change of the growth reactor 10 and without interruption of growth.

After the epitaxial growth of these layers, an epitaxial wafer 33 is obtained as shown in Fig. 4 (c).

In step S110, electrodes are formed on the epitaxial wafer 33. An anode is formed on the p-type GaN layer 29 and a cathode is formed on the back surface of the substrate 11.

Although the growth temperature T3 of the p-type gallium nitride based semiconductor layers 27 and 29 is higher than the growth temperature TW of the well layers 23a-23c and the growth temperature TB of the barrier layers 21a-21d, degradation of crystal quality in the well layers 23a-23c is suppressed during the growth of the p-type gallium nitride based semiconductor layers 27 and 29 because the growth temperature TW (= T2) of the well layers 23a-23c is the same as the growth temperature TB (= T2) of the barrier layers 21a-21d.

The growth temperature T3 of the p-type gallium nitride based semiconductor layers 27 and 29 can be more than 950 Celsius degrees and not more than 1000 Celsius degrees. Since the growth temperature T3 of the p-type gallium nitride semiconductor layers 27 and 29 is in the above temperature range, the crystal quality and electrical characteristics of the p-type gallium nitride based semiconductor layers 27 and 29 both are made excellent. Furthermore, the quality of the active layer is also made excellent.

The p-type gallium nitride based semiconductor region 31 includes the AlGaN layer, and in the foregoing temperature range, the crystal quality and electrical characteristics of the AlGaN layer of the p-type gallium nitride based semiconductor region both are made excellent.

The thickness of the p-type gallium nitride based semiconductor region 31 can be not less than 40 nm and not more than 200 nm. Since the p-type gallium nitride based semiconductor region 31 is grown at the high temperature of more than 950 Celsius degrees and not more than 1000 Celsius degrees, creation of pits is suppressed in the p-type gallium nitride based semiconductor region 31. Since the grown surface of the p-type gallium nitride based semiconductor region 31 can be made flat, it becomes feasible to grow the p-type contact layer thick in order to lower the resistance of the p-type gallium nitride based semiconductor region 31. The range of such thickness is, for example, not less than 10 nm and not more than 100 nm.

A temperature difference between a maximum temperature in the growth of the p-type gallium nitride based semiconductor region 31 and the growth temperature of the well layers 23a-23c (which is equal to the growth temperature of the barrier layers) can be not more than 250 degrees. This can reduce the degradation, which is caused during the growth of the p-type gallium nitride based semiconductor region 31, of the crystal quality of the active layer. The temperature difference between the maximum of the growth temperature of the p-type gallium nitride based semiconductor region 31 and the growth temperature of the well layers 23a-23c can be not less than 140 Celsius degrees. The p-type gallium nitride based semiconductor region 31 with excellent crystal quality can be obtained.

An indium composition of the well layers 23a-23c is not less than 0.20 and not more than 0.25, and a peak wavelength of light emitted from the active layer 25 is not less than 500 nm. At the peak wavelength, the emission intensity of the light from the active layer 25 can have the maximum. In the indium composition of the well layers 23a-23c in the foregoing range, since the growth temperature TW of the well layers 23a-23c is equal to the growth temperature TB of the barrier layers 21a-21d, this growth method can suppress the degradation, caused during the growth of the p-type gallium nitride based semiconductor layers 27 and 29 and the barrier layers 21a-21d, of the crystal quality of the well layers 23a-23c.

### (Example 1)

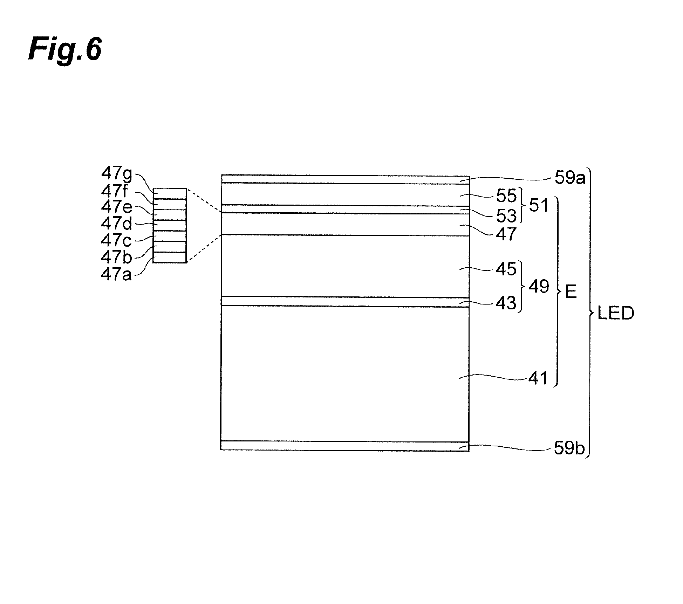

Fig. 6 is a drawing showing a light emitting diode structure LED fabricated in the present example. Plural GaN wafers 41 are prepared and each GaN wafer has a primary surface of a gallium nitride based semiconductor. An off angle of the primary surfaces of the GaN wafers 41 is an angle from 5 degrees to 10 degrees defined with respect to a c-plane of GaN. The GaN wafers 41 have n-conductivity, and the primary surface thereof has semipolar nature. Gallium nitride based semiconductor films are grown on these GaN wafers 41 by the metal-organic vapor phase epitaxial method. The raw materials used in the metal-organic vapor phase epitaxial method are as follows: trimethyl gallium (TMG), trimethyl aluminum (TMA), trimethyl indium (TMI), and ammonia (MH₃). Dopants used herein are as follows: silane (SiH₄) and bis(cyclopentadienyl)magnesium (Cp₂Mg). The GaN wafer is placed in a growth reactor, and thereafter the GaN wafer 41 is subjected to thermal cleaning. For this thermal treatment, hydrogen and ammonia are supplied into the growth reactor. The temperature of the thermal treatment is, for example, 1050 Celsius degrees. The temperature of the thermal treatment applicable herein is in the range of not less than 1000 Celsius degrees and not more than 1100 Celsius degrees. After the thermal treatment, an n-type AlGaN buffer layer 43 is grown thereon. The growth temperature of the buffer layer is, for example, 1100 Celsius degrees. An Al composition of the buffer layer is 0.12. A dopant concentration of the n-type AlGaN layer 43 is, for example, 1×10¹⁸ cm⁻³, and the thickness thereof is, for example, 50 nm.

An n-type GaN semiconductor layer 45 is grown on this buffer layer 43. A growth temperature of the semiconductor layer 45 is, for example, 1000 Celsius degrees. A dopant concentration of the n-type GaN layer 45 is, for example, 2×10¹⁸ cm⁻³, and the thickness thereof is, for example, 2000 nm.

The temperature of the growth reactor is changed to a growth temperature of active layer 47, and thereafter the active layer 47 is grown on the foregoing n-type gallium nitride based semiconductor region 49. The growth temperature of the active layer 47 is, for example, 760 Celsius degrees. First, a barrier layer 47a of GaN is grown thereon. The thickness of the barrier layer 47a is 15 nm. Next, a well layer 47b of InGaN is continuously grown, without interruption of growth. The thickness of the well layer 47b is 5 nm. An indium composition of the well layer 47b is 20%. Subsequently, a barrier layer 47c of GaN is continuously grown on the well layer 47b, without interruption of growth. Similarly, the growth of well layers 47d and 47f and barrier layers 47e and 47g is repeatedly carried out to form the active layer 47 that includes the three layers of well layers 47b, 47d and 47f.

After completion of the growth of the active layer 47, the temperature of the growth reactor was changed to a growth temperature of a p-type gallium nitride based semiconductor region 51. This temperature is, for example, 1000 Celsius degrees. First, a p-type AlGaN layer 53 is grown on the active layer 47. An Al composition of the layer 53 is 0.18. A dopant concentration of the p-type AlGaN layer 53 is, for example, 5×10¹⁷ cm⁻³, and the thickness thereof is, for example, 20 nm. After the growth, a p-type GaN layer 55 is grown on the p-type AlGaN layer 53. A dopant concentration of the p-type GaN layer 55 is, for example, 1×10¹⁸ cm⁻³, and the thickness thereof is, for example, 50 nm.

An epitaxial wafer E is completed through these epitaxial growth steps.

An anode electrode 59a is formed on the contact layer of p-type GaN layer 57. The anode electrode 59a used herein is, for example, Ni/Au. Next, the back surface of the GaN wafer of the substrate product is ground into the thickness of 100 µm to produce a substrate product. A cathode electrode 59b is formed on the ground back surface. The cathode electrode 59b used herein is, for example, Al.

For comparison, an epitaxial wafer C is fabricated using the temperatures of 760 Celsius degrees as the growth temperature of the well layers and 940 Celsius degrees as the growth temperature of the barrier layers.

The two types of epitaxial wafers fabricated as described above are measured by X-ray diffraction. The intensities of first-order satellite peaks (arbitrary unit) are as follows.
Epitaxial wafer E: 28-32;
Epitaxial wafer C: 5-15.
As such, the epitaxial wafer E shows the excellent intensities of the first-order satellite peaks, indicating that the interfaces between the well layers and the barrier layers of the epitaxial wafer E are made abrupt.

The inventors conduct research to grow the well layers and barrier layers of the active layer at various temperatures in which the well layers and barrier layers are grown at the same temperature. The temperatures are in the range of not less than 760 Celsius degrees and not more than 800 Celsius degrees.

The well layers are grown at a flow rate of an indium source suitable for an intended emission wavelength (e.g., an emission wavelength of not less than 500 nm). The barrier layers are grown at the same temperature as the growth temperature of the well layers. The growth temperature of the InGaN well layers with the In composition for achieving the emission wavelength of not less than 500 m has to be in a low temperature range of not more than 800 Celsius degrees. Accordingly, the temperature difference between the well layers and the barrier layers becomes as large as about 100 degrees, and during a temperature rise process to achieve this temperature difference, the well layers are etched to cause degradation of the well layers. As a result of this phenomenon, the photoluminescence spectrum intensity decreased.

At emission wavelengths of not more than 440 nm, the temperature difference between the well layers and the barrier layers is smaller than the foregoing value, the temperature rise period is also small, and the indium composition of the well layers is also small; therefore, the degradation of the well layers due to the growth with the temperature difference is small as a result. Furthermore, when the temperature of the barrier layers is set higher than the growth temperature of the well layers, the crystal quality of the barrier layers improves, so as to increase the emission intensity as a result.

On the other hand, in the emission wavelength range of not more than 440 nm, the indium composition of the well layers becomes larger, so that the temperature difference between the well layers and the barrier layers needs to be increased, and the temperature rise period also increase; therefore, the degradation of the well layers due to the growth temperature difference becomes significant as a result. Hence, the emission intensity becomes lower.

Accordingly, in order to make a full width at half maximum of the PL spectrum not more than 40 nm, it is preferable to grow the well layers and the barrier layers at the same growth temperature. In order to achieve a large efficiency of injection into the well layers, the number of the well layers in the active layer can be from 2 to 5.

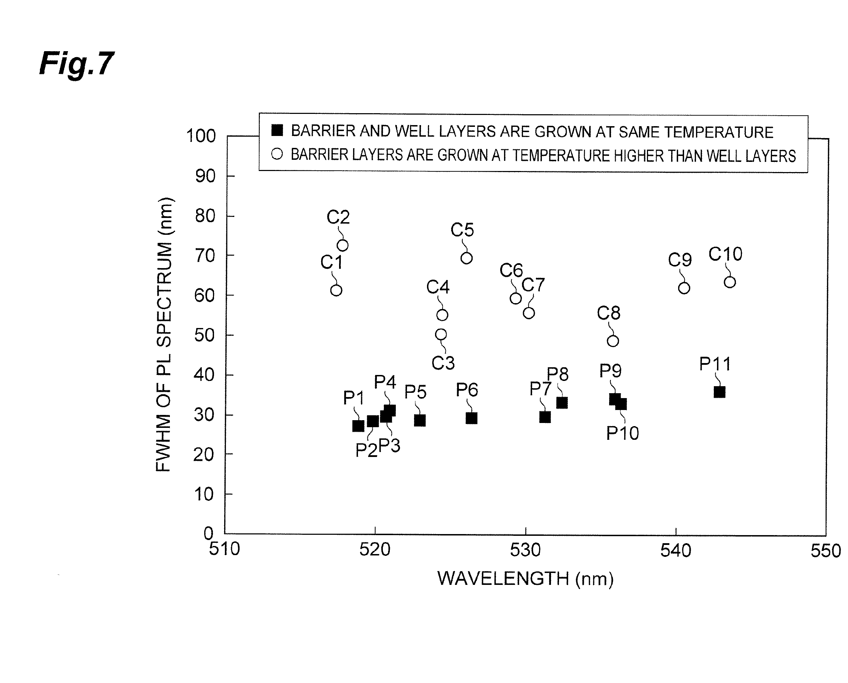

Fig. 7 is a drawing showing full widths at half maximum of PL intensity in LED structures fabricated under a variety of growth conditions. With reference to Fig. 7, there are shown plots P1-P11 of LED structures obtained by growing the well layers and the barrier layers at the same temperature, and plots C1-C10 of LED structures obtained by growing the well layers and the barrier layers at different temperatures.
The results of the plots P1-P11 are as follows.

| Sample | Growth | Thicknesses of | Full width at |
|---|---|---|---|
| name, | temperature, | well layers/barrier layers, | half maximum |
| plot P1: | 770 °C, | 3nm/15mn, | 27 nm; |
| plot P2: | 760°C, | 2.7nm/15nm, | 29 nm; |
| plot P3: | 760°C, | 3nm/15nm, | 30 nm; |
| plot P4: | 760°C, | 3nm/15nm, | 31 nm; |
| plot P5: | 760°C, | 3nm/15nm, | 29 nm; |
| plot P6: | 760°C, | 3nm/15nm, | 29 nm; |
| plot P7: | 760°C, | 3nm/15nm, | 29 nm; |
| plot P8: | 760°C, | 3nm/15nm, | 33 nm; |
| plot P9: | 760°C, | 3nm/15nm, | 34 nm; |
| plot P10: | 760°C, | 3nm/15nm, | 33 nm; |
| plot P11 | 760°C, | 3nm/15nm, | 36 nm. |

The results of the plots C1-C10 are as follows.

| Sample name, | Growth temperatures (wells/barriers), | Thicknesses of well layers/barrier layers, | Full width at half maximum |
|---|---|---|---|
| plot C1: | 750°C/840°C, | 3nm/15nm, | 61 nm; |
| plot C2: | 750°C/840°C, | 3nm/15nm, | 72 nm; |
| plot C3: | 760°C/840°C, | 3nm/15nm, | 50 nm; |
| plot C4: | 750°C/840°C, | 3nm/15nm, | 55 nm; |
| plot C5: | 760°C/840°C, | 3nm/15nm, | 70 nm; |
| plot C6: | 760°C/840°C, | 3nm/15nm, | 59 nm; |
| plot C7: | 760°C/820°C, | 3nm/15nm, | 56 nm; |
| plot C8: | 760°C/840°C, | 3nm/15nm, | 49 nm; |
| plot C9: | 760°C/840°C, | 3nm/15nm, | 62 nm; |
| plot C10: | 760°C/840°C, | 3nm/15nm, | 64 nm. |

When the barrier layers and the well layers are grown at the same growth temperature, the full width at half maximum is improved in the wavelength region of not less than the emission wavelength of 500 nm, and, in InGaN with a large indium composition (e.g., 0.2 or more), the indium composition fluctuates. Because of this fluctuation, after the growth of the well layer, an etching amount in the surface of the well layer varies during the temperature rise to the growth temperature of the barrier layer. When the growth of the well layers is carried out at the temperature different from that of the growth of the barrier layers, a distribution of full widths at half maximum becomes larger as indicated by plots "o" in Fig. 7. It is considered that in-plane distributions of full widths at half maximum and peak wavelengths become larger because of the foregoing variation. On the other hand, when the barrier layers and the well layers are grown at the same growth temperature, the distribution of full widths at half maximum becomes larger, as indicated by plots "■."

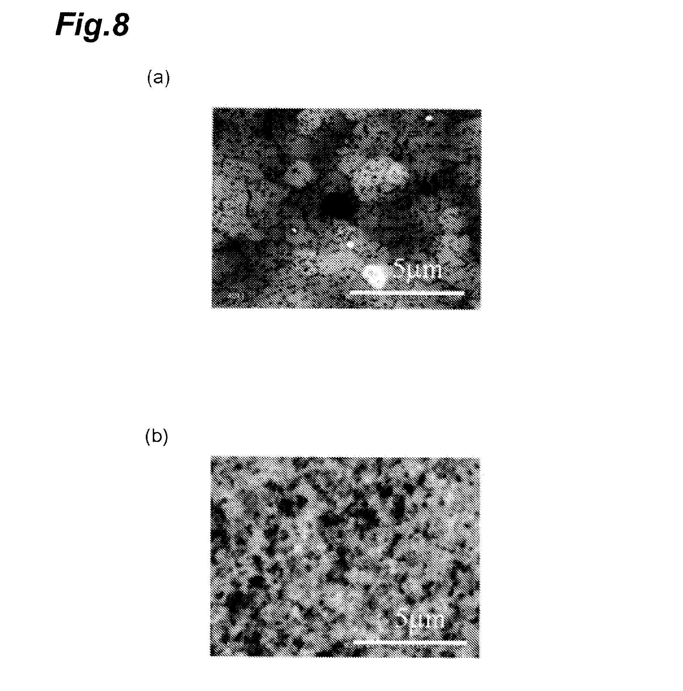

Fig. 8 (a) shows a cathodoluminescence image of an LED structure formed by growing the well layers and the barrier layers at the same temperature, and Fig. 8 (b) shows a cathodoluminescence image of an LED structure obtained by growing the well layers and the barrier layers at different temperatures. It is shown with reference to Fig. 8 (a) that the emission image is uniform and the emission is even, whereas portions observed in black are shown with reference to Fig. 8 (b). The black portions corresponds to non-emitting regions, and the emission image is nonuniform.

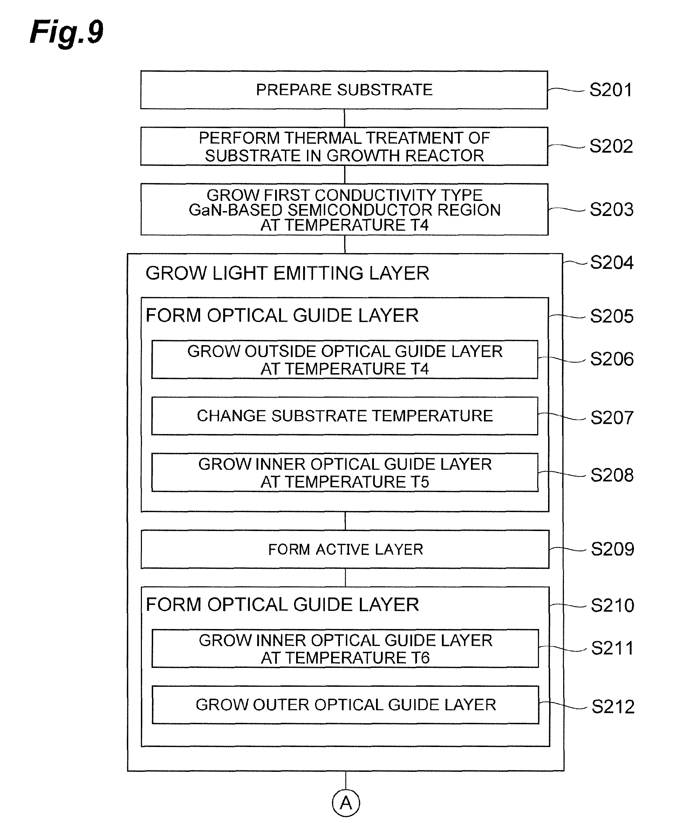

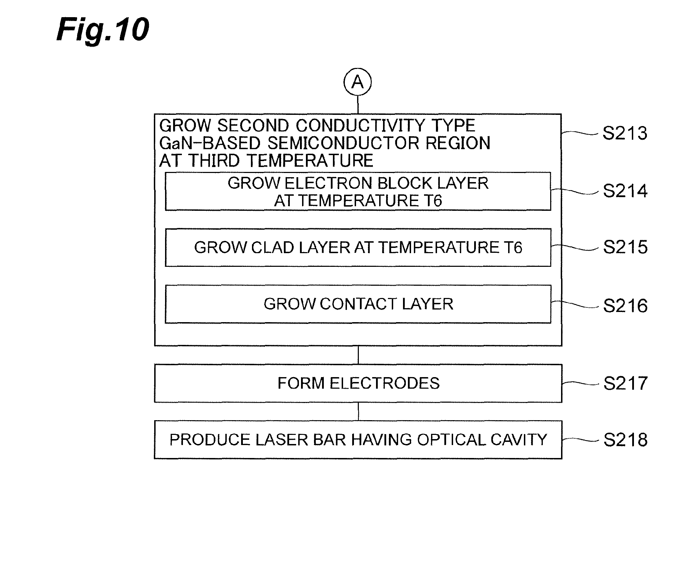

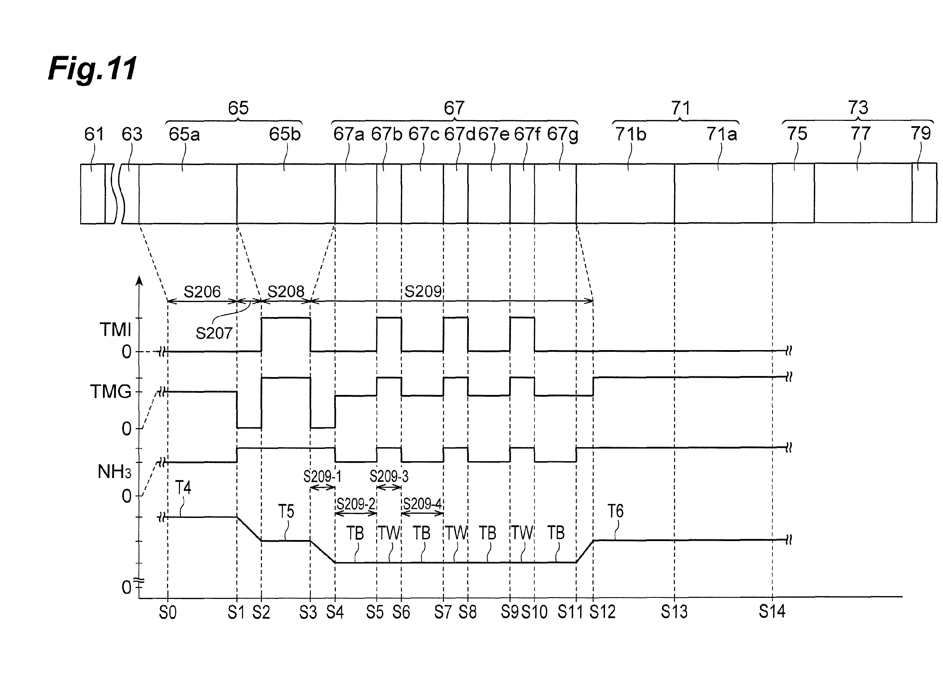

Another nitride semiconductor light emitting device will be described below. This nitride semiconductor light emitting device has, for example, a structure suitable for a laser diode. Figs. 9 and 10 are drawings showing a flow of major steps in a method of fabricating a nitride semiconductor light emitting device and a method of fabricating an epitaxial wafer according to an embodiment of the present invention. Fig. 11 is a timing chart showing change in substrate temperature and change in raw-material gas flow in steps of formation of a light emitting layer and steps subsequent thereto.

### (Example 2)

In step S201, several GaN wafers 61 are prepared and each of GaN wafers 61 has a primary surface of a gallium nitride based semiconductor. The primary surface of these GaN wafers 61 has a (20-21) plane, inclined at the angle of 75 degrees from the c-axis toward the m-axis, as a constituent plane. The GaN wafers 61 have n-conductivity and the primary surface thereof has semipolar nature. Gallium nitride based semiconductor films are grown on these GaN wafers 61 by the metal-organic vapor phase epitaxial method. Raw materials used in the metal-organic vapor phase epitaxial method are as follows: trimethyl gallium (TMG), trimethyl aluminum (TMA), trimethyl indium (TMI), and ammonia (MH₃). Dopants used herein are as follows: silane (SiH₄) and bis(cycpentadienyl) magnesium (Cp₂Mg). After the GaN wafer 61 is placed in a growth reactor, step S202 is carried out to subject the GaN wafer 61 to thermal cleaning. For this thermal treatment, hydrogen and ammonia are supplied into the growth reactor. The temperature of the thermal treatment is, for example, 1050 Celsius degrees. The temperature of the thermal treatment applicable herein is in the range of not less than 1000 Celsius degrees and not more than 1100 Celsius degrees.

After the thermal treatment, step S203 is carried out to grow a gallium nitride based semiconductor layer 63 at a substrate temperature T4. The gallium nitride based semiconductor layer 63 grown herein can be InAIGaN, AlGaN, GaN, or the like. In the present example, it is grown, for example, as an n-type InAlGaN layer containing at least gallium, indium, and aluminum as Group III elements and nitrogen as a Group V element. The growth temperature of the semiconductor layer 63 was, for example, 1100 Celsius degrees. An Al composition of the semiconductor layer 63 is, for example, 0.14 and an indium composition thereof is, for example, 0.03. A dopant concentration (e.g., silicon) of the n-type InAlGaN layer is, for example, 1×10¹⁸ cm⁻³, and the thickness thereof is, for example, 2300 nm. This n-type InAlGaN layer 63 functions, for example, as an n-type cladding layer.

In step S204, a light emitting layer is formed on this cladding layer 63. In the step of forming the light emitting layer, an optical guide layer 65 is first grown thereon in step S205. Steps from growth of an n-side optical guide layer to growth of a p-side optical guide layer will be described with reference to Fig. 11. The optical guide layer 65 comprises a gallium nitride based semiconductor with a bandgap smaller than that of the cladding layer 63. First, step S206 is carried out to grow a GaN semiconductor layer 65a on the cladding layer 63 at a growth temperature T4 during a period from time S0 to S1. The growth temperature T4 is, for example, 1100 Celsius degrees. The GaN layer 65 is doped, for example, with an n-type dopant, and a dopant concentration (e.g., silicon) thereof is, for example, 1.0×10¹⁸ cm⁻³. The thickness of the semiconductor layer 65a is, for example, 250 nm. In step S207, the substrate temperature is changed from the growth temperature T4 for the GaN semiconductor layer 65a to a growth temperature T5 for InGaN semiconductor layer 65b during a period from time S 1 to S2. Next, step S208 is carried out to grow an InGaN semiconductor layer 65b on the GaN semiconductor layer 65a during a period from time S2 to S3. The growth temperature T5 of the semiconductor layer 65b is, for example, 890 Celsius degrees. The InGaN layer 65b is, for example, undoped. The thickness of the semiconductor layer 65b is, for example, 100 nm, and an indium composition thereof is, for example, 0.03.

In step S209, an active layer 67 is grown thereon. In step S209-1, the substrate temperature is changed from the growth temperature for the InGaN semiconductor layer 65b to a growth temperature for the active layer 67 during a period from time S3 to S4. After this temperature change, the active layer 67 is grown on the aforementioned n-type gallium nitride based semiconductor region 63 and InGaN semiconductor layer 65b. The growth temperature of the active layer 67 is, for example, 720 Celsius degrees. First, in step S209-2, TMG and ammonia are supplied into the growth reactor during a period from time S4 to S5 to grow a barrier layer 67a of GaN. The thickness of the barrier layer 67a is 15 nm. Next, in step S209-3, TMG, TMI, and ammonia are supplied into the growth reactor during a period from time S5 to S6 to continuously grow a well layer 67b of InGaN without interruption of growth. The thickness of the well layer 67b is 3 nm. An indium composition of the well layer 67b is 0.30. Subsequently, in step S209-4, a barrier layer 67c of GaN is continuously grown on the well layer 67b during a period from time S6 to S7 without interruption of growth. Similarly, growth of well layers 67d, 67f as in step S209-3 and growth of barrier layers 67e, 67g as in step S209-4 are repeatedly carried out during a period from time S7 to S8, during a period from time S9 to S10, during a period from time S8 to S9, and during a period from time S10 to S 11, respectively, thereby forming the active layer 67 that includes the three layers of well layers 67b, 67d and 67f. After completion of the growth of the barrier layer 67g at time S11, the substrate temperature is changed from the growth temperature T5 for the active layer 67 to a growth temperature T6 for InGaN semiconductor layer 71b during a period from time S11 to S12. The well layers are made undoped. The barrier layers can be, for example, undoped.

In step S210, an optical guide layer 71 is grown thereon. This optical guide layer 71 is grown prior to growth of p-type gallium nitride based semiconductor region 73. The optical guide layer 71 includes a gallium nitride based semiconductor having a bandgap smaller than that of the p-type gallium nitride based semiconductor region 73. First, in step S211 an InGaN semiconductor layer 71b is grown on the active layer 67 during a period from time S12 to S13. A growth temperature of the semiconductor layer 71b is, for example, 890 Celsius degrees. The InGaN layer 71b is, for example, undoped. The thickness of the semiconductor layer 71b is, for example, 100 nm, and an indium composition thereof is 0.03. Next, in step S212, a GaN semiconductor layer 71 a is grown on the InGaN semiconductor layer 71b during a period from time S 13 to S 14 without temperature change. A growth temperature of the semiconductor layer 71a is, for example, 890 Celsius degrees. The GaN layer 65 is doped, for example, with a p-dopant; a dopant concentration (e.g., magnesium) thereof is, for example, 3×10¹⁸ cm⁻³; and the thickness thereof is, for example, 250 nm.

Subsequently, the p-type gallium nitride based semiconductor region 73 is grown thereon in step S213. In the present example, the growth temperature for the p-type gallium nitride based semiconductor region 73 is the same as the growth temperature for the optical guide layer. If necessary, the substrate temperature can be changed from the growth temperature for the optical guide layer to the growth temperature for the p-type gallium nitride based semiconductor region 73 (for example, an electron block layer, a cladding layer, and a contact layer), and in this example, the substrate temperature is changed to the growth temperature of the p-type gallium nitride based semiconductor region 73 by regulating the temperature of the growth reactor. In the present example, the temperature for the p-type gallium nitride based semiconductor region 73 is, for example, 890 Celsius degrees. First, in step S214, a p-type gallium nitride based semiconductor layer 75 is grown on the active layer 67 and the optical guide layer 71. The p-type gallium nitride based semiconductor layer 75 grown herein is, for example, an AlGaN layer. This AlGaN layer acts, for example, as an electron block layer. An Al composition of the semiconductor layer is, for example, 0.11; a dopant concentration thereof is, for example, 3×10¹⁸ cm⁻³; and the thickness thereof is, for example, 10 nm. The electron block layer can be located, for example, between the active layer and the optical guide layer, or between the inner optical guide layer and the outer optical guide layer.

After this, step S215 was carried out to grow a gallium nitride based semiconductor layer 77. The gallium nitride based semiconductor layer 77 can be comprised, for example, of p-type InAlGaN, a p-type AlGaN semiconductor, or the like. In the present example, the gallium nitride based semiconductor layer 77 grown herein may be a gallium nitride semiconductor layer containing at least gallium, indium and aluminum as Group III elements and nitrogen as a Group V element. A growth temperature of the semiconductor layer 77 is, for example, 890 Celsius degrees. An Al composition of the semiconductor layer 77 is 0.14 and an indium composition is thereof 0.03. A dopant concentration (e.g., magnesium) of the gallium nitride based semiconductor layer 77 is, for example, 1×10¹⁸ cm⁻³, and the thickness thereof is, for example, 400 nm. This InAlGaN layer acts, for example, as a cladding layer.

In step S216, a p-type gallium nitride based semiconductor layer 79 is grown on the gallium nitride based semiconductor layer 77. This p-type gallium nitride based semiconductor layer 79 includes a gallium nitride based semiconductor, such as GaN, AlGaN, or InAlGaN, having a bandgap smaller than that of the gallium nitride based semiconductor layer 77. In the present example, a p-type GaN layer is grown as the p-type gallium nitride based semiconductor region 79. A dopant concentration of the p-type GaN layer is, for example, 1×10¹⁸ cm⁻³, and the thickness thereof is, for example, 50 nm. The p-type GaN layer acts, for example, as a contact layer.

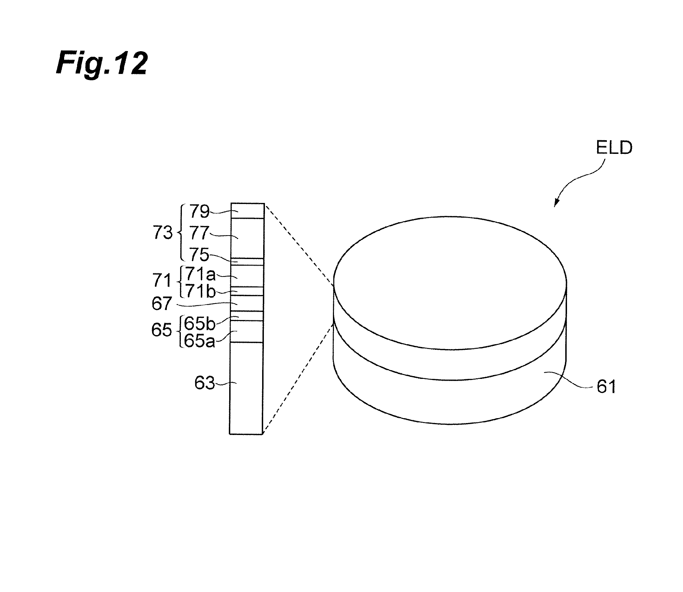

An epitaxial wafer ELD shown in Fig. 12 is completed through these epitaxial growth steps. This epitaxial wafer ELD includes a laser diode structure formed on the semipolar substrate having the primary surface inclined at an angle of 75 degrees. A photoluminescence (PL) spectrum is measured for the epitaxial wafer ELD. The full width at half maximum of the PL spectrum is 30 nm. This full width at half maximum shows a spectrum better, as compared with other growth flows. Since the active layer is formed at the single temperature, the light emitting layer is grown without degradation of quality.

In step S217, electrodes are formed on the epitaxial wafer ELD. For example, an anode electrode 59a is formed on the contact layer of p-type GaN layer 79. The anode electrode 81a used herein is, for example, Ni/Au. Next, the back surface of the GaN wafer of this substrate product is ground to the thickness of 100 µm to fabricate a substrate product. A cathode electrode 81b is formed on this ground back surface. The cathode electrode 81b used herein was, for example, Al. The substrate product including the laser diode structure formed on the semipolar substrate of the primary surface inclined at an angle of 75 degrees is fabricated through these steps.

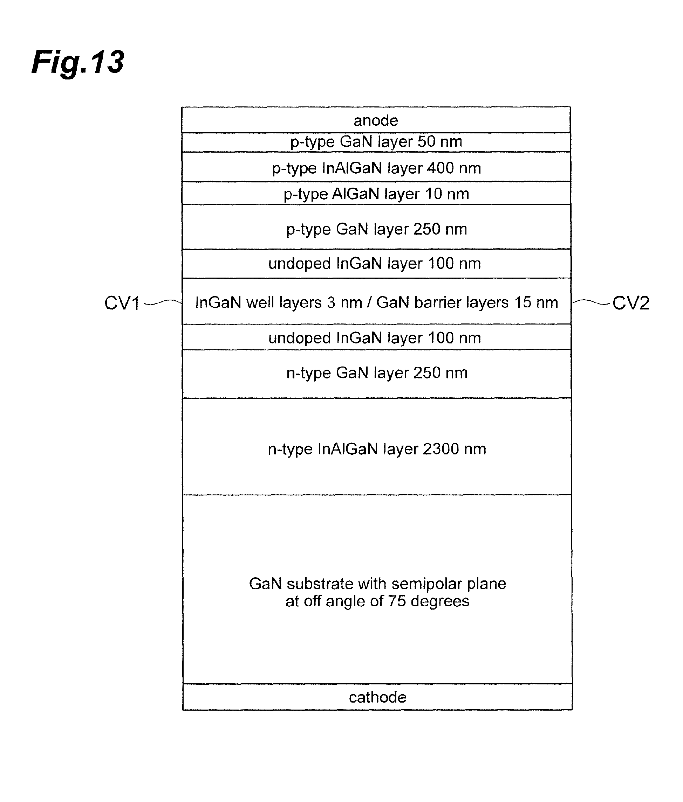

In step S217, a laser bar is formed from the substrate product. The laser bar is produced by breaking the substrate product at an interval of 800 µm. Fig. 13 is a drawing showing the laser diode structure LD produced in the present example. The laser diode structure LD shown in Fig. 13 includes a pair of cross sections CV1, CV2 for an optical cavity. The laser diode structure including this optical cavity permits lasing at the lasing wavelength of 520 nm. The threshold current density of the laser diode structure is not more than 4 kA/cm².

From the results based on the experiment in Example 2 above and other experiments, the fabrication of the laser diode will be described below. The growth temperature of the InGaN well layers and the barrier layers is preferably not less than 700 Celsius degrees. Furthermore, the growth temperature of the InGaN well layers and the barrier layers is preferably not more than 760 Celsius degrees. This range is applicable to formation of the active layer to emit light at the peak wavelength among emission wavelengths of not less than 400 nm and not more than 540 nm. This temperature range can avoid the degradation of the emission property due to the crystal quality of the InGaN layer.

The growth temperature of the p-type gallium nitride based semiconductor region is preferably more than 850 Celsius degrees. The growth temperature of more than 850 Celsius degrees can suppress the degradation of the device characteristics due to increase in resistance in the p-type gallium nitride based semiconductor region. The growth temperature of the p-type gallium nitride based semiconductor region is preferably not more than 950 Celsius degrees. The growth temperature of not more than 950 Celsius degrees can reduce the thermal degradation of InGaN during the growth of the p-type gallium nitride based semiconductor region.

The temperature difference between the maximum of the growth temperature of the p-type gallium nitride based semiconductor region and the growth temperature of the well layers is preferably not more than temperature of 200 degrees. In order to increase the emission wavelength in manufacture of the light emitting device, the growth temperature of the InGaN well layers is adjusted relatively low, and the In composition of the InGaN well layers is adjusted relatively high. In these settings, the quality of InGaN becomes sensitive to thermal stress after film formation thereof. In order to avoid thermal degradation of this InGaN, it is preferable not to use a high growth temperature for growth of the p-type gallium nitride based semiconductor region.

The indium composition of the well layers is preferably not less than 0.25 and not more than 0.35, and the lasing wavelength of the light emitted from the active layer can be not less than 500 nm. In this laser diode, the active layer can generate green light or light at a wavelength longer than the green light.

Furthermore, the thickness of the p-type gallium nitride based semiconductor region is preferably not less than 50 nm and not more than 700 nm. This method can provide the excellent optical confinement as a whole of the p-type gallium nitride based semiconductor region. The thickness of the cladding layer can be, for example, not less than 50 nm and not more than 700 nm.

As shown in Fig. 13, the nitride semiconductor light emitting device preferably further comprises the end faces for the optical cavity thereof. When the inclination angle of the primary surface of the GaN substrate for the nitride semiconductor light emitting device is in the angle range of not less than 63 degrees and not more than 83 degrees, an excellent performance of In incorporation is achieved in growth of InGaN. Accordingly, the range of change in In composition of the well layers can be enlarged, which is preferable for production of the active layer to emit light at the wavelength of not less than 500 nm.

The principle of the present invention has been illustrated and described in the preferred embodiments thereof, and it can be understood by those skilled in the art that the present invention can be modified in arrangement and detail without departing from the principle thereof. The present invention is by no means limited to the specific configurations disclosed in the embodiments. Therefore, we claim all the modifications and changes coming from the scope of claims and spirit thereof.

### List of Reference Signs

- 11: substrate;
- 11a,: primary surface of substrate;
- 11b: back surface of substrate;
- 11c: modified primary surface of substrate;
- 10: growth reactor;
- 13: gallium nitride based semiconductor region;
- 15: n-type AlGaN buffer layer;
- 17: n-type GaN layer;
- 25: active layer;
- 21a,21b,21c,21d: barrier layers;
- 23a, 23b, 23c: well layers;
- TB: (= T2) growth temperature of barrier layers;
- TW: (=T2) growth temperature of well layers;
- 27: electron block layer;
- 29: contact layer;
- 31: gallium nitride based semiconductor region;
- 33: epitaxial wafer;
- 41: GaN wafer;
- 43: n-type AlGaN layer;
- 45: n-type GaN semiconductor layer;
- 47: active layer;
- 47a,: 47c, 47e, 47g barrier layers;
- 47b,: 47d, 47f well layers;
- 49: n-type gallium nitride based semiconductor region;
- 51: p-type gallium nitride based semiconductor region;
- 53: p-type AlGaN layer;
- 55: p-type GaN layer;
- 59a: anode electrode;
- 59b: cathode electrode;
- C: epitaxial wafer;
- E: epitaxial wafer;
- 61: GaN wafer;
- 63: gallium nitride based semiconductor layer;
- 65: optical guide layer;
- 65a: GaN semiconductor layer;
- 65b: InGaN semiconductor layer;
- 67: active layer;
- 67a, 67c, 67e, 67g: barrier layers;
- 67b, 67d, 67f: well layers;
- 71: optical guide layer;
- 71b: InGaN semiconductor layer;
- 71a: GaN semiconductor layer;
- 73: p-type gallium nitride based semiconductor region;
- 75: p-type gallium nitride based semiconductor layer;
- 77: gallium nitride based semiconductor layer;
- 79: p-type gallium nitride based semiconductor layer;
- ELD: epitaxial wafer.

## Claims

1. A method of fabricating a nitride semiconductor light emitting device, comprising the steps of:
growing a barrier layer for an active layer on a primary surface of a semiconductor region of a gallium nitride based semiconductor;
growing a well layer for the active layer on the barrier layer; and
growing a p-type gallium nitride based semiconductor region on the active layer,
the primary surface of the semiconductor region being inclined with respect to a c-plane of the gallium nitride based semiconductor to have semipolar nature,
the well layer comprising InGaN,
an indium composition of the well layer being not less than 0.15,
the barrier layer comprising a gallium nitride based semiconductor different from that of the well layer,
a growth temperature of the well layer being the same as a growth temperature of the barrier layer,
the p-type gallium nitride based semiconductor region including one or more p-type gallium nitride based semiconductor layers, and
a growth temperature of each of the p-type gallium nitride based semiconductor based layers being larger than the growth temperature of the well layer and the growth temperature of the barrier layer.

2. The method according to claim 1, wherein a normal vector normal to the primary surface of the semiconductor region is inclined at an angle in a range of not less than 60 degrees and not more than 90 degrees with respect to a normal vector normal to one of a c-plane ((0001) plane) and a (000-1) plane, and the (000-1) plane is a reverse of the c-plane.

3. The method according to claim 1 or claim 2, wherein an indium composition of the well layer is not less than 0.20, and
wherein the active layer is provided so as to generate light having a peak wavelength in a wavelength range of not less than 500 nm.

4. The method according to any one of claims 1 to 3, wherein the growth temperature of the well layer and the growth temperature of the barrier layer are not more than 800 Celsius degrees, and
wherein the growth temperature of the p-type gallium nitride based semiconductor region is not more than 1000 Celsius degrees.

5. The method according to any one of claims 1 to 4, wherein the growth temperature of the well layer and the growth temperature of the barrier layer are not less than 700 Celsius degrees and not more than 760 Celsius degrees.

6. The method according to any one of claims 1 to 5, wherein the growth temperature of the p-type gallium nitride based semiconductor region is more than 850 Celsius degrees and not more than 950 Celsius degrees.

7. The method according to any one of claims 1 to 6, wherein a temperature difference between a maximum of the growth temperature of the p-type gallium nitride based semiconductor region and the growth temperature of the well layer is not more than 200 degrees.

8. The method according to any one of claims 1 to 7, wherein an indium composition of the well layer is not less than 0.25 and not more than 0.3 5, and
wherein a lasing wavelength of light emitted from the active layer is not less than 500 nm.

9. The method according to any one of claims 1 to 8, wherein a thickness of the p-type gallium nitride based semiconductor region is not less than 50 nm and not more than 700 nm.

10. The method according to any one of claims 1 to 4, wherein the growth temperature of the well layer and the growth temperature of the barrier layer are not less than 760 Celsius degrees and not more than 800 Celsius degrees.

11. The method according to any one of claims 1 to 4 and claim 10, wherein the growth temperature of the p-type gallium nitride based semiconductor region is more than 950 Celsius degrees and not more than 1000 Celsius degrees.

12. The method according to any one of claims 1 to 4 and claims 10 and 11, wherein an indium composition of the well layer is not less than 0.20 and not more than 0.25,
wherein a peak wavelength of light emitted from the active layer is not less than 500 nm, and
wherein an emission intensity of the light from the active layer shows a maximum at the peak wavelength.

13. The method according to any one of claims 1 to 4 and claims 10 to 12, wherein a thickness of the p-type gallium nitride based semiconductor region is not less than 40 nm and not more than 200 nm.

14. The method according to any one of claims 1 to 4 and claims 10 to 13, wherein a temperature difference between a maximum of the growth temperature of the p-type gallium nitride based semiconductor region and the growth temperature of the well layer is not more than 250 degrees.

15. The method according to any one of claims 1 to 14, wherein the p-type gallium nitride based semiconductor region includes an AlGaN layer.

16. The method according to any one of claims 1 to 15, further comprising the step of preparing a substrate, the substrate comprising a gallium nitride based semiconductor,
wherein a primary surface of the substrate is inclined with respect to a c-plane of the gallium nitride based semiconductor.

17. The method according to any one of claims 1 to 15, further comprising the step of preparing a substrate, the substrate comprising a gallium nitride based semiconductor,
wherein the primary surface of the substrate is inclined with respect to a (000-1) plane and the (000-1) plane is a reverse of a c-plane ((0001) plane).

18. The method according to claim 16 or claim 17, wherein an inclination angle of the primary surface of the substrate is not less than 60 degrees and not more than 90 degrees.

19. The method according to any one of claims 14 to 18, further comprising an end face for an optical cavity thereof, and
wherein an inclination angle of the primary surface of the substrate is not less than 63 degrees and not more than 83 degrees.

20. The method according to any one of claims 1 to 19, further comprising the step of performing a thermal treatment of the substrate, prior to growth of the gallium nitride based semiconductor,
wherein an atmosphere of the thermal treatment includes ammonia and hydrogen.

21. A method of fabricating an epitaxial wafer for a nitride semiconductor light emitting device, comprising the steps of:
growing a barrier layer for an active layer on a primary surface of a semiconductor region, the semiconductor region comprising a gallium nitride based semiconductor;
growing a well layer for the active layer on the barrier layer; and
growing a p-type gallium nitride based semiconductor layer on the active layer,
the primary surface of the semiconductor region being inclined with respect to a c-plane of the gallium nitride based semiconductor to have semipolar nature,
the barrier layer comprising a gallium nitride based semiconductor different from that of the well layer,
the well layer comprising InGaN,
an indium composition of the well layer being not less than 0.15,
a growth temperature of the well layer being the same as a growth temperature of the barrier layer,
the p-type gallium nitride based semiconductor region including one or more p-type gallium nitride based semiconductor layers, and
a growth temperature of each of the p-type gallium nitride based semiconductor layers being larger than a growth temperature of the well layer and a growth temperature of the barrier layer.
